# EUROPEAN PATENT SPECIFICATION

(11) **EP 3 574 334 B1**
(45) Date of publication and mention of the grant of the patent: **09.08.2023**
(21) Application number: 17837855.0
(22) Date of filing: 27.12.2017
(51) Int. Cl.: G01R 33/04

(54) **A MAGNETIC FIELD SENSOR**
MAGNETFELDSENSOR
CAPTEUR DE CHAMP MAGNÉTIQUE

(30) Priority: 26.01.2017 GB 201701297
(43) Date of publication of application: 04.12.2019
(73) Proprietor: Gill Corporate Limited, Dorset BH15 2PW (GB)
(72) Inventor: GILL, Michael John, Beaulieu Hampshire SO42 7XA (GB)
(74) Representative: Hanson, William Bennett
(86) International application number: PCT/EP2017/025373
(87) International publication number: WO 2018/137750

(56) References cited:
- EP-A1- 2 075 814
- EP-A2- 0 227 888
- JP-A- 2014 071 101
- US-A- 5 537 038
- US-A1- 2008 292 044
- US-A1- 2013 214 777
- US-A1- 2015 048 820
- US-A1- 2016 109 533
- US-A1- 2016 245 878
- US-B2- 9 239 365

## Description

The present invention relates to a magnetic field sensor for determining the strength and/or direction of a component of an ambient magnetic field, comprising electrical circuitry which incorporates a magnetic sensing element, a voltmeter connected in the circuitry to provide a measure of the voltage across the magnetic sensing element, an electrical energy supply connector connected to the magnetic sensing element to supply an electrical current which passes through that element when the sensor is in use, and switches to reverse the direction of the flow of electrical current through the magnetic sensing element between successive measurements of the said voltage by the said voltmeter.

In one such magnetic field sensor which has already been proposed, the magnetic sensing element comprises a flux meter in which the current is passed through a primary winding, and the voltage is measured across a secondary winding. This requires a measurement of peak voltages which is of limited accuracy.

US 2015/048820 A1 discloses compact, low power fluxgate magnetic sensor readout circuits and apparatus in which a demodulator or rectifier circuit modulates a sense signal from the fluxgate sense coil, and the demodulated signal is provided to an amplifier circuit with a transconductance or other amplifier and one or more feedback capacitors connected between the amplifier input and amplifier output to integrate the amplifier output current and provide a voltage output signal indicating the magnetic field sensed by the fluxgate sensor.

EP 2075814 A discloses a magnetic flux measuring device and magnetic flux measuring method for stationary induction electrical apparatus which can accurately measure the magnetic flux without being influenced by the DC offset component which superimposes on the measurement system, and can constantly and continuously measure the magnetic flux without setting a limit in the magnetic flux measurement period. The magnetic flux measuring method which measures a magnetic flux of a stationary induction electrical apparatus using a voltage waveform of the stationary induction electrical apparatus, wherein the magnetic flux of the stationary induction electrical apparatus is determined by the steps of: inputting a voltage waveform of the stationary induction electrical apparatus into a negative-feedback amplification means of which feedback circuit is constructed by a low pass filter; and integrating output of the negative-feedback amplification means by integration means.

US 2016/245878 A1 discloses a magnetic field measuring device including a first sensor unit which includes a first coil sensor configured to output a first sensor signal, a second sensor unit which includes a second coil sensor configured to output a second sensor signal and disposed in a direction perpendicular to the first coil sensor, a third sensor unit which includes a third coil sensor configured to output a third sensor signal and disposed in a direction perpendicular to the first and second coil sensors, and a digital signal processor outputs magnetic flux density based on a voltage difference between the first and fourth nodes, wherein the first to third sensor units respectively output first to third output signals in which specific voltages of the first to third sensor signals are maintained for a predetermined period of time.

EP 0227888 A2 discloses a quick ranging technique controlled by a microcomputer, in which predetermined stepped adjustments are made to the charge times in a ranging circuit to bring the charge time into a required range, thereby minimising calibration time for an electronic compass; a digital filter also controlled by the microcomputer smooths out the magnetic field component signals.

US 2013/214777 A1 discloses a semiconductor integrated circuit which includes a clock-signal control circuit controlling intensity-signal output, which is output from a signal processing circuit, to be stopped in at least a forward outage time and a backward outage time. The forward outage time is previous to an apex point of a triangular wave and having 1 to 5% of a triangular wave period. The backward outage time is subsequent to the apex point of the triangular wave and having 1 to 5% of a triangular wave period.

US 5537038 A discloses a current of predetermined frequency which is fed to a coil wound around a ferromagnetic core through a fixed impedance means. A magnetic flux measurement is performed in terms of a level of a DC component of a voltage generated across the coil. A DC bias is added to the current of predetermined frequency, and the resultant current is applied through the fixed impedance means to the coil wound around the ferromagnetic core. A magnetic flux measurement is performed in terms of a level of a DC component of the voltage across the coil. A magnetic flux measuring method and apparatus for embodying the same have a high sensitivity in detecting a minute magnetic flux and an improved temperature characteristic because an output voltage little varies against a temperature variation. A magnetic flux measuring method and apparatus for embodying the same, when they are applied to a leakage flux flaw detection using a saturable magnetic flux sensor, is capable of expanding a measuring span of the magnetic flux sensor, thereby to improve a flaw detection performance.

US2008/292044 A1 discloses a signal detection circuit comprising: a differential amplifier to which an output voltage of a detection coil of a magnetic sensor is to be applied; a comparator to output a digital signal being at one logic level in a period between two spike-shaped voltages adjacent to each other in the output voltage of the differential amplifier; and a count circuit to perform a count operation in a period during which the comparator outputs the digital signal of the one logic level, the count circuit including a first counter to count a first clock having a predetermined frequency, a second counter to count a second clock being equal in frequency to and different in phase from the first clock, the second counter having the same number of bits as the number of bits of the first counter, and an adder to add count values of the first and the second counter.

US 9239365 B2 discloses a magnetic element control device which includes an excitation signal generation unit that generates an alternating signal, a feedback signal conversion unit that converts a time width between detection signals of a positive voltage and a negative voltage into voltage information, an adjustment signal generation unit that generates an offset signal that cancels an offset component which is superimposed on a data signal indicating a magnetic field intensity, and an excitation signal adjustment unit that generates an alternating current, a feedback current, and an offset current from the alternating signal, the feedback signal, and the offset signal, respectively, superimposes the feedback current and the offset current on the alternating current, and generates an excitation current which is applied to an exciting coil.

Another magnetic field sensor is disclosed in US 5757184. In that sensor, a measurement is made of the time it takes for a response waveform to rise to a predetermined threshold, and this measurement also is of limited accuracy.

The present invention seeks to provide a remedy.

Accordingly, a first aspect of the present invention is directed to a magnetic field sensor according to claim 1.

The timer may be a part or parts of the processor, which may be a microprocessor. This enables economy of manufacture.

The switches may be parts of the processor or microprocessor. Again, this affords an economy of parts in the manufacture of the sensor.

The timer may be provided with a memory in which is retained the value of ΔT. Again, this affords an economy of parts.

The voltmeter may comprise an amplifier connected in series with an analogue-to-digital converter between the magnetic sensing element and the processor or microprocessor, and the voltmeter may be made as an integral part or parts of the microprocessor, again for economy of parts.

The present invention extends to a compass provided with a magnetic field sensor in accordance with the present invention.

According to a second aspect of the present invention, there is provided a method of determining the strength and/or direction of a component of an ambient magnetic field, according to claim 8.

The present invention extends to such a method using a sensor or a compass as set out in any one of the foregoing paragraphs between the one commencing "According to a first aspect" and the one commencing "According to a second aspect".

Examples of a sensor, compass and method embodying the present invention will now be described in greater detail with reference to the accompanying drawings, in which:
Figure 1 shows a circuit diagram of a sensor embodying the present invention,
Figure 2 shows a perspective end view of a magnetic sensing element of the circuitry shown in Figure 1; and
Figures 3 to 5 show respective explanatory graphs.

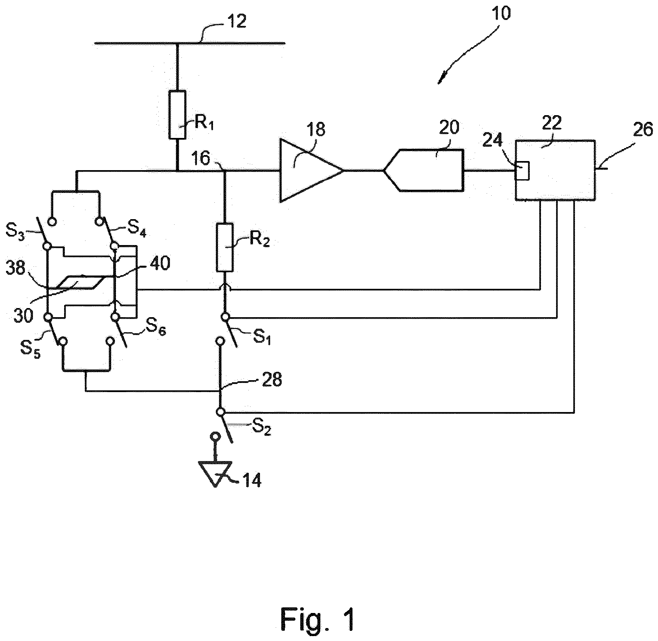

The magnetic field sensor 10 shown in Figure 1 comprises an electrical energy source connector 12 for connecting the sensor 10 to a source of electrical energy (not shown) at voltage V, and an earth connector 14 for connecting the sensor 10 to earth or equivalent. Between the connectors 12 and 14, from the connector 12 to the connector 14, are two resistances R₁ and R₂ connected in series with one another, followed by two switches S₁ and S₂ also connected in series with one another.

The interconnection 16 between the resistors R1 and R2 is connected to the input of an amplifier 18 the output from which is connected to the input of an analogue to digital converter 20, the output from which is connected to an input of a microprocessor 22 via a timer 24. An output 26 of the microprocessor 22 provides a digital output which can be connected to any other digital system, for example a meteorological system (not shown), or a navigation system (not shown).

Connected across the interconnection 16 and the interconnection 28 between the switches S₁ and S₂ is a magnetic sensing element 30, via switches S₃, S₄, S₅, and S₆.

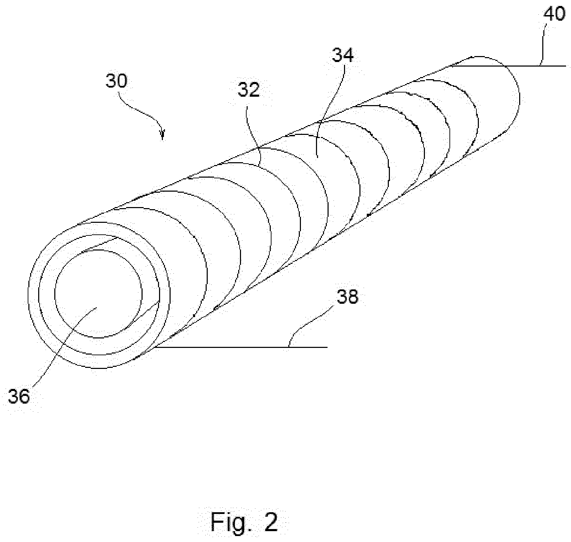

As shown in Figure 2, the magnetic sensing element 30 comprises a coil 32 wound around and along a hollow cylindrical non-electrically conductive nonmagnetic former 34 within and along the interior of which extends a solid cylindrical core 36 of a ferromagnetic material such as iron.

The coil has opposite ends 38 and 40 respectively connected to the interconnections (a) between switches S₃ and S₅ and (b) between switches S₄ and S₆. One side of each of the switches S₃ and S₄ is connected to the interconnection 16, and the other sides of the switches S₃ and S₄ are connected respectively to the ends 38 and 40 of the coil 32. Similarly, one side of each of the switches S₅ and S₆ is connected to the interconnection between the switches S₁ and S₂, and the other sides of the switches S₅ and S₆ are connected respectively to the ends 38 and 40 of the coil 32.

All the switches S₁ to S₆ are simple on-off switches connected to the microprocessor 22 for control thereby.

The magnetic sensing element 30 is one of three (the other two of which are not shown) each mounted orthogonally relative to the other two, and each with circuitry as shown in Figure 1 but sharing a common microprocessor 22 which addresses the three elements cyclically. Signals from the three sensors taken together are used in a manner known in itself to provide an indication of the strength and direction of the ambient magnetic field, as described for example with reference to Figure 20 of US 5757184.

With the connector 12 connected to a source of energy so that it is held at voltage V, at time T₀ the microprocessor 22 sets switches S₂, S₄ and S₅ closed, and switches S₃, S₆ and S₁ open. After a predetermined period of time set by the microprocessor 22, at time T₃, switch S₂ remains closed and switch S₁ remains open, but the conditions of all the other switches S₃ to S₆ are reversed, so that simultaneously switches S₃ and S₆ are closed, and switches S₄ and S₅ are opened. At time T₄, being a predetermined period after time T₃ equal to or about equal to the period between times T₀ and T₃, the conditions of switches S₃ to S₆ remain unchanged, but the conditions of switches S₁ and S₂ are reversed, so that switch S₂ is opened and switch S₁ is closed.

At time T₅, being after time T₄ by a period also about equal to that between times T₀ and T₃, the conditions of switches S₃ to S₆ again remain unchanged, but the conditions of the switches S₁ and S₂ are reversed again back to the condition they had between times T₀ and T3.

Upon completion of a further period after time T₅, about the same as that between times T₀ and T₂, at time T₆, the conditions of the switches S₁ and S₂ remain unaltered, but those of switches S₃ to S₆ are reversed back to the condition they had between times T₀ and T₃.

Upon completion of a further such period after time T₆, at time T₇, the conditions of switches S₃ to S₆ remain unchanged, but those of switches S₁ and S₂ are once again reversed. Finally, after a further such period, the conditions of switches S₃ to S₆ remain unchanged, but the conditions of switches S₁ and S₂ are reversed to recommence this cycle of switching the switches S₁ to S₆.

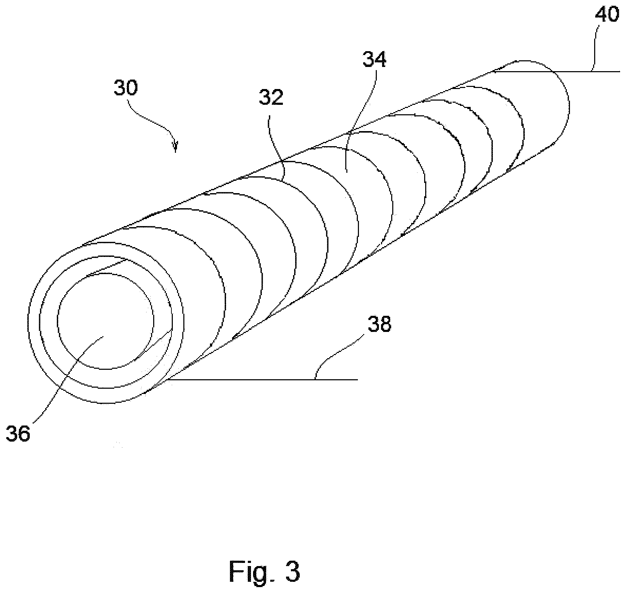

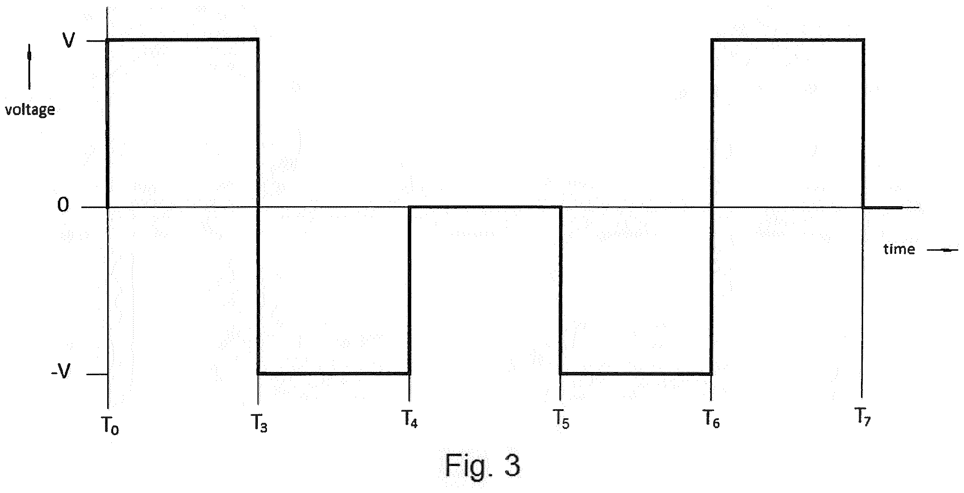

It will be appreciated that the resulting voltage applied across the combination of resistor R₁ and the magnetic sensing element 30, with the direction of the voltage being dependent on the direction of this applied voltage relative to the coil 32, is as shown in Figure 3.

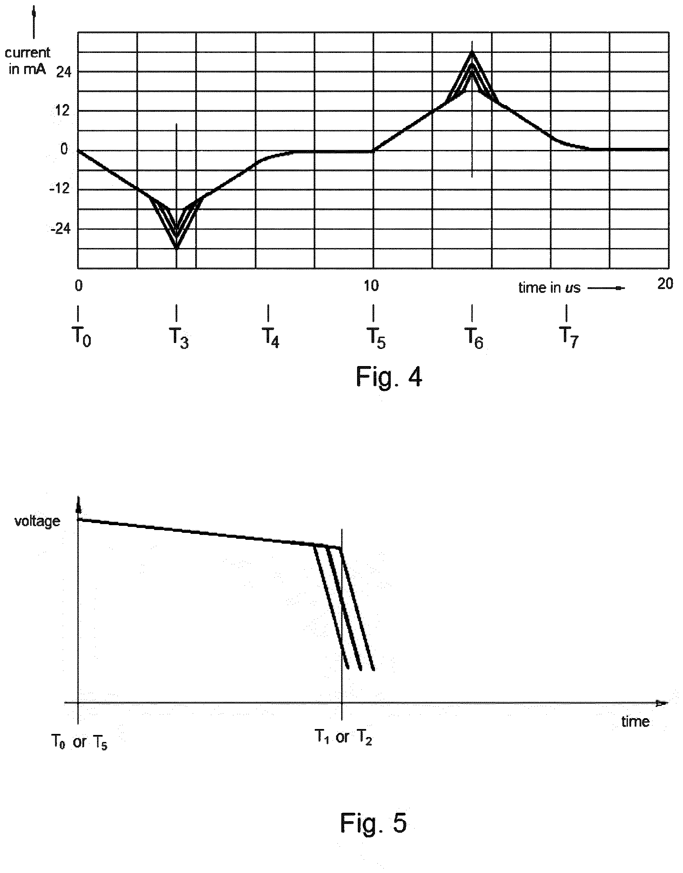

During successive cycles, the current flowing through the coil 32 is as shown in Figure 4. Which of the troughs and peaks shown at times T₃ and T₆ actually occurs, at around the time when the direction of applied voltage is reversed, depends upon the strength and direction of the ambient magnetic field.

Thus, during the period from T₀ to T₃, the negative current passing through the coil 32 steadily increases as more and more of the respective magnetic fields of the magnetic domains in the core 36 align themselves with the magnetic field generated within the coil 32 by the electrical current passing through it. The current is considered negative because of the direction of flow of the current through the coil at this stage, so that an increase in the negative current is indicated by a fall in the plot of current as a function of time in the graph shown in Figure 4. When the magnetisation of the core 36 is saturated, the negative electrical current increases at an even greater rate. The point in time at which this happens will be dependent upon the ambient magnetic field, because that field will itself cause a certain degree of alignment or anti-alignment of the magnetic fields of those domains.

At the time T₃, the direction of the current through the coil 32 is reversed, and the plot of current against time reverses so that the plot of current versus time at this stage is more or less symmetrical about time T₃. This is so until the magnetic energy stored in the core 36 is almost zero at time T₄ when the ends of the coil 32 are connected across the resistor R₂ to completely remove the energy at which point the current passing through the coil 32 is zero.

The next half of the cycle of switching results in a similar process but with the current passing in a positive direction through the coil 32, so that the plot of current versus time in the right-hand side of Figure 4 is a vertical inversion of the plot of current versus time in the left-hand side of that Figure. However, for any non-zero value of the ambient magnetic field, it will be appreciated that the size of the negative peak and the positive peak at times T₃ and T₆ will be different for any actual plot of current versus time. In other words, the time it takes for saturation of the core 36 to be reached will be different for one direction of current flow than it is for the opposite direction of current flow.

Figure 5 shows a graph of the voltage at the interconnection 16 plotted against time. Which of the steeper falls at the right hand side of the plot actually occurs again depends upon the strength and direction of the ambient magnetic field. Because of the linearity of the function, and the spacing between successive steep lines corresponding to equal increments of strength in the ambient magnetic field, it can be seen that the value of the voltage at a time passed by all the steep lines varies in proportion to the strength of that field, in fact in inverse proportion, so that the stronger the ambient magnetic field, the lower the measured voltage at that time.

The actual times at which the voltage at interconnection 16 is made are at times T₁ and T₂, respectively at equal periods of time ΔT after times T₀ and T₅, respectively just before times T₃ and T₆ when the applied voltage is reversed.

The period ΔT is stored in the timer 24, which is restarted on every occurrence of the times T₀ and T₅ in each cycle. When the count in the timer 24 equals ΔT, the value of the voltage at interconnection 16 is read by the microprocessor 22 from the input it receives from the analogue to digital converter 20. The microprocessor 22 then calculates the value of the difference between two successive readings. The magnitude of the difference between two successive readings gives the strength of the component of the ambient magnetic field which is in alignment with the axis of the coil 32, and the sign of the difference gives the direction of that component.

With measurements from the three mutually orthogonal magnetic sensing elements 30, the microprocessor 22 programmed in a manner known in itself to cause the display 26 to display the direction of North, being the direction in which the field is indicated to be strongest and of the appropriate sign, the sensor acts as a compass.

Numerous variations and modifications to the illustrated sensor may occur to the reader without taking the resulting construction outside the scope of the present invention. For example, the switches S₁ to S₆, the resistors R₁ and R₂, the amplifier 18 and the analogue to digital converter 20 could all be incorporated in the microprocessor 22.

## Claims

1. A magnetic field sensor (10) for determining the strength and/or direction of a component of an ambient magnetic field, comprising electrical circuitry which incorporates:
a magnetic sensing element (30) comprising a coil (32) surrounding magnetic material (36),
a voltmeter (22) connected in the circuitry to provide a measure of the voltage across the magnetic sensing element (30),
an electrical energy source connector (12) connected to the magnetic sensing element (30) to supply an electrical current which passes through that element (30) when the sensor (10) is in use, and
switches (S₃, S₄, S₅ and S₆) to reverse the direction of the flow of electrical current through the magnetic sensing element (30) between successive measurements of the said voltage by the said voltmeter (22), the electrical energy source connector (12) and the said switches (S₃, S₄, S₅ and S₆) being connected to the said coil (32),
wherein the voltmeter (22) is connected to measure the voltage across the said coil (32), and the circuitry further comprises a timer (24) connected within the circuitry to cause the voltmeter (22) to provide measurements V₁ and V₂ respectively at times T₁ and T₂ which occur during saturation of the magnetic material (36) after successive operations of the switches (S₃, S₄, S₅ and S₆) respectively at times T₀ and T₅, to initiate the passage of electrical current through the coil (32) in respective opposite directions, such that T₁ - T₀ = T₂ - T₅ = ΔT, where ΔT is a predetermined period of time, and a processor (22) is connected in the circuitry to provide an indication of the value of V₁-V₂, the magnitude of which provides an indication of the strength of the said component, and the sign of which provides an indication of the direction of the said component.

2. A magnetic field sensor (10) according to claim 1, wherein the timer (24) is a part or parts of the processor (22), especially but not exclusively a microprocessor.

3. A magnetic field sensor according to claim 1 or claim 2, wherein the switches (S₃, S₄, S₅ and S₆) are parts of the processor (22) or microprocessor.

4. A magnetic field sensor (10) according to any preceding claim, wherein the voltmeter (22) is a part or parts of the processor (22) or microprocessor.

5. A magnetic field sensor (10) according to any preceding claim, wherein the timer (24) is provided with a memory in which is retained the value of ΔT.

6. A magnetic field sensor (10) according to any preceding claim, wherein the voltmeter (22) comprises an amplifier (18) connected in series with an analogue-to-digital converter (20) between the magnetic sensing element (30) and the processor (22) or microprocessor.

7. A compass provided with a magnetic field sensor (10) as claimed in any preceding claim.

8. A method of determining the strength and/or direction of a component of an ambient magnetic field, comprising obtaining a measure of the voltage V₁ across a magnetic sensing element (30), in the form of a coil (32) surrounding magnetic material (36), of electrical circuitry of a magnetic field sensor (10) by means of a voltmeter (22) of the electrical circuitry at a time T₁ during saturation of the magnetic material (36) after a time T₀ when an electrical current through the coil in a first direction is initiated by switches (S₁ to S₆) of the circuitry, using a timer (24) to equate T₁-T₀ to a predetermined period ΔT, and obtaining a measure of the voltage V₂ across the coil at a time T₂ also during saturation of the magnetic material (36) after a time T₅ when an electrical current through the coil in the direction opposite to the said first direction is initiated by the switches (S₃, S₄, S₅ and S₆), equating T₂-T₅ to the predetermined period ΔT, and using a processor (22) of the circuitry to provide an indication of the value of V₁-V₂, the magnitude of which provides an indication of the strength of the said component, and the sign of which provides an indication of the direction of the said component.

9. A method of determining the strength and/or direction of a component of an ambient magnetic field, using a magnetic field sensor (10) as claimed in any one of claims 2 to 7 according to the method of claim 8.

## Patentansprüche

1. Magnetfeldsensor (10) zur Bestimmung der Stärke und/oder Richtung einer Komponente eines umgebenden Magnetfeldes, der eine elektrische Schaltung umfasst, die Folgendes enthält
ein magnetisches Sensorelement (30) mit einer Spule (32), die magnetisches Material (36) umgibt,
einen Spannungsmesser (22), der in die Schaltung geschaltet ist, um ein Maß für die Spannung über dem magnetischen Sensorelement (30) bereitzustellen,
einen Anschluss (12) für eine elektrische Energiequelle, der mit dem magnetischen Sensorelement (30) verbunden ist, um einen elektrischen Strom zu liefern, der durch dieses Element (30) fließt, wenn der Sensor (10) in Gebrauch ist, und
Schalter (S₃, S₄, S₅ und S₆), um die Richtung des Stromflusses durch das magnetische Sensorelement (30) zwischen aufeinanderfolgenden Messungen der Spannung durch den Spannungsmesser (22) umzukehren, wobei der Verbinder der elektrischen Energiequelle (12) und die Schalter (S₃, S₄, S5 und S₆) mit der Spule (32) verbunden sind,
wobei der Spannungsmesser (22) so angeschlossen ist, dass er die Spannung an der Spule (32) misst, und die Schaltung ferner einen Zeitgeber (24) umfasst, der innerhalb der Schaltung angeschlossen ist, um den Spannungsmesser (22) zu veranlassen, Messungen Vᵢ bzw. V₂ zu Zeitpunkten'l_{'l} und T₂ zu liefern, die während der Sättigung des magnetischen Materials (36) nach aufeinanderfolgenden Betätigungen der Schalter (S₃, S₄, S₅ und S₆) zu Zeitpunkten Tₒ bzw. T₅ auftreten, um den Durchgang von elektrischem Strom durch die Spule (32) in jeweils entgegengesetzten Richtungen zu initiieren, so dass Tᵢ - Tₒ = T₂ - T₅ = ΔT, wobei ΔT eine vorbestimmte Zeitspanne ist, und ein Prozessor (22) in die Schaltung geschaltet ist, um eine Anzeige des Wertes von V₁-V₂ zu liefern, dessen Betrag eine Anzeige der Stärke der genannten Komponente liefert und dessen Vorzeichen eine Anzeige der Richtung der genannten Komponente liefert.

2. Magnetfeldsensor (10) nach Anspruch 1, wobei der Zeitgeber (24) ein Teil oder Teile des Prozessors (22), insbesondere aber nicht ausschließlich ein Mikroprozessor, ist.

3. Magnetfeldsensor nach Anspruch 1 oder Anspruch 2, wobei die Schalter (S₃, S₄, S₅ und S₆) Teile des Prozessors (22) oder Mikroprozessors sind.

4. Magnetfeldsensor (10) nach einem der vorhergehenden Ansprüche, wobei der Spannungsmesser (22) ein Teil oder Teile des Prozessors (22) oder Mikroprozessors ist.

5. Magnetfeldsensor nach einem der vorhergehenden Ansprüche, wobei der Zeitgeber (24) mit einem Speicher versehen ist, in dem der Wert von ΔT gespeichert wird.

6. Magnetfeldsensor (10) nach einem der vorhergehenden Ansprüche, wobei der Spannungsmesser (22) einen Verstärker (18) umfasst, der in Reihe mit einem Analog-DigitalWandler (20) zwischen dem Magnetsensorelement (30) und dem Prozessor (22) oder Mikroprozessor angeschlossen ist.

7. Kompass mit einem Magnetfeldsensor (10) nach einem der vorhergehenden Ansprüche.

8. Verfahren zum Bestimmen der Stärke und/oder Richtung einer Komponente eines umgebenden Magnetfeldes, umfassend das Erhalten eines Maßes für die Spannung Vi über einem magnetischen Sensorelement (30) in Form einer Spule (32), die magnetisches Material (36) umgibt, einer elektrischen Schaltung eines Magnetfeldsensors (10) mittels eines Spannungsmessers (22) der elektrischen Schaltung zu einem Zeitpunkt Tᵢ während der Sättigung des magnetischen Materials (36) nach einem Zeitpunkt Tₒ, wenn ein elektrischer Strom durch die Spule in einer ersten Richtung durch Schalter (S₁ bis S₆) der Schaltung eingeleitet wird, unter Verwendung eines Zeitgebers (24), um 'I_{'I}-'I_{'O} mit einer vorbestimmten Periode ΔT gleichzusetzen, und Erhalten eines Maßes der Spannung V₂ an der Spule zu einem Zeitpunkt T₂ auch während der Sättigung des magnetischen Materials (36) nach einem Zeitpunkt T₅, wenn ein elektrischer Strom durch die Spule in der der ersten Richtung entgegengesetzten Richtung durch die Schalter (S₃, S₄, S₅ und S₆) eingeleitet wird, Gleichsetzen von T₂-T₅ mit der vorbestimmten Periode ΔT, und Verwenden eines Prozessors (22) der Schaltung, um eine Anzeige des Wertes von V₁-V₂ zu liefern, dessen Betrag eine Anzeige der Stärke der Komponente liefert, und dessen Vorzeichen eine Anzeige der Richtung der Komponente liefert.

9. Verfahren zur Bestimmung der Stärke und/oder Richtung einer Komponente eines umgebenden Magnetfeldes unter Verwendung eines Magnetfeldsensors (10) nach einem der Ansprüche 2 bis 7 gemäß dem Verfahren nach Anspruch 8.

## Revendications

1. Capteur de champ magnétique (10) pour déterminer l'intensité et/ou la direction d'une composante d'un champ magnétique ambiant, comprenant un circuit électrique qui incorpore:
un élément de détection magnétique (30) comprenant une bobine entourant un matériau magnétique (36),
un voltmètre (22) connecté dans le circuit pour fournir une mesure de la tension à travers l'élément de détection magnétique (30),
un connecteur d'une source en énergie électrique (12) relié à l'élément de détection magnétique (30) pour fournir un courant électrique qui traverse cet élément (30) lorsque le capteur (10) est en service, et
des commutateurs (S₃, S₄, S₅ et S₆) pour inverser la direction du flux de courant électrique à travers l'élément de détection magnétique (30) entre des mesures successives de ladite tension par ledit voltmètre (22), le connecteur d'une source en énergie électrique (12) et lesdits commutateurs (S₃, S₄, S₅ et S₆) étant connectés à ladite bobine (32),
dans lequel le voltmètre (22) est connecté pour mesurer la tension à travers ladite bobine (32), et le circuit comprend en outre un minuteur (24) connecté à l'intérieur du circuit pour amener le voltmètre (22) à fournir des mesures V₁ et V₂ respectivement aux instants T₁ et T₂ qui interviennent durant la saturation du noyau matériau magnétique (36) après des opérations successives des commutateurs (S₃, S₄, S₅ et S₆) respectivement aux instants T₀ et T₅, pour initier le passage du courant électrique à travers la bobine (32) dans des directions opposées respectives, de sorte que T₁- T₀ = T₂ - T₅ = ΔT, où ΔT est une période de temps prédéterminée, et un processeur (22) est connecté dans le circuit pour fournir une indication de la valeur de V₁ -V₂, dont l'amplitude fournit une indication de l'intensité de ladite composante, et dont le signe fournit une indication de la direction de ladite composante.

2. Capteur de champ magnétique (10) selon la revendication 1, dans lequel le minuteur (24) est une partie ou des parties du processeur (22), notamment mais pas exclusivement un microprocesseur.

3. Capteur de champ magnétique selon la revendication 1 ou la revendication 2, dans lequel les commutateurs (S₃, S₄, S₅ et S₆) sont des parties du processeur (22) ou du microprocesseur.

4. Capteur de champ magnétique (10) selon l'une quelconque des revendications précédentes, dans lequel le voltmètre (22) est une partie ou des parties du processeur (22) ou du microprocesseur.

5. Capteur de champ magnétique (10) selon l'une quelconque des revendications précédentes, dans lequel le minuteur (24) est pourvu d'une mémoire dans laquelle est conservée la valeur de ΔT.

6. Capteur de champ magnétique (10) selon l'une quelconque des revendications précédentes, dans lequel le voltmètre (22) comprend un amplificateur (18) connecté en série avec un convertisseur analogique-numérique (20) entre l'élément de détection magnétique (30) et le processeur (22) ou le microprocesseur.

7. Compas muni d'un capteur de champ magnétique (10) comme revendiqué dans l'une quelconque des revendications précédentes.

8. Procédé pour déterminer l'intensité et/ou de la direction d'une composante d'un champ magnétique ambiant, comprenant l'obtention d'une mesure de la tension V₁ à travers un élément de détection magnétique (30), sous la forme d'une bobine (32) entourant un matériau magnétique (36), d'un circuit électrique d'un capteur de champ magnétique (10) au moyen d'un voltmètre (22) du circuit électrique à un instant T₁ durant la saturation du noyau matériau magnétique (36) après un temps T₀ lorsqu'un courant électrique à travers la bobine dans une première direction est initié par des commutateurs (S₁ à S₆) du circuit, l'utilisation d'un minuteur (24) pour mettre en équivalence T₁ - T₀ à une période prédéterminée ΔT, l'utilisation d'une mesure de la tension V₂, à travers la bobine à un instant T₂ également durant la saturation du noyau matériau magnétique (36) après un instant T₅ lorsqu'un courant électrique traversant la bobine dans la direction opposée à ladite première direction est initié par les commutateurs (S₃, S₄, S₅ et S₆), la mise en équivalence T₂-T₅ à la période ΔT prédéterminée, et l'utilisation d'un processeur (22) du circuit pour fournir une indication de la valeur de V₁-V₂, dont l'amplitude fournit une indication de l'intensité de ladite composante, et dont le signe fournit une indication de la direction de ladite composante.

9. Procédé pour déterminer l'intensité et/ou de la direction d'une composante d'un champ magnétique ambiant, utilisant un capteur de champ magnétique (10) comme revendiqué dans l'une quelconque des revendications 2 à 7 et selon le procédé de la revendication 8.
